Europäisches Patentamt

European Patent Office

Office européen des brevets

(19)

(11) Numéro de publication: **0 029 809**

**B1**

(12) **FASCICULE DE BREVET EUROPEEN**

(45) Date de publication du fascicule du brevet: **15.02.84**

(21) Numéro de dépôt: **80810354.3**

(22) Date de dépôt: **18.11.80**

(51) Int. Cl.³: **C 23 C 11/00,**
**C 03 C 17/245**

(54) Buse pour déposer en continu sur un substrat une couche d'une matière solide.

(30) Priorité: **21.11.79 CH 10377/79**

(43) Date de publication de la demande:
**03.06.81 Bulletin 81/22**

(45) Mention de la délivrance du brevet:
**15.02.84 Bulletin 84/7**

(84) Etats contractants désignés:
**BE CH DE FR GB IT LI LU NL SE**

(56) Documents cités:
**DE - A - 2 123 274**
**DE - A - 3 005 797**
**FR - A - 2 015 789**
**FR - A - 2 348 165**
**US - A - 3 511 703**

(73) Titulaire: **Societa Italiana Vetro - SIV - S.P.A**
**I-66050 San Salvo (Chieti) (IT)**

(72) Inventeur: **Kalbskopf, Reinhard**
**103, Avenue du Bois de la Chapelle**
**CH-1213 Onex (CH)**
Inventeur: **Baumberger, Otto Bastian**
**rue des Caroubiers, 18**
**CH-1227 Carouge (CH)**

(74) Mandataire: **Dousse, Blasco et al,**
**7, route de Drize**
**CH-1227 Carouge/Genève (CH)**

Courier Press, Leamington Spa, England.

Buse pour deposer en continu sur un substrat une couche d'une matiere solide

La présente invention se rapporte à une buse pour déposer en continu sur un substrat une couche d'une matière solide par réaction d'au moins deux réactifs gazeux ou en suspension dans un gaz.

Il a déjà été proposé dans le brevet suisse No 628 600 d'effectuer un dépôt en continu d'une couche d'une matière solide par réaction de deux réactifs gazeux sur un substrat relativement large, en particulier une feuille de verre plat. Ce procédé est connu sous le sigle C.V.D. de la dénomination angalise "Chemical Vapor Deposition". C'est ainsi que l'on dépose à l'aide de ce procédé des couches minces transparentes de $SnO_2$ ou de $TiO_2$ par réaction de $SnCl_4$ respectivement de $TiCl_4$ et de $H_2O$ dilués dans un gaz porteur amenés en contact de la surface du verre préalablement chauffé à une température de l'ordre de 400°C à 600°C.

L'installation pour la mise en oeuvre de ce procédé comporte notamment une buse présentant trois fentes rectilignes adjacentes dont les parois latérales délimitant les bords longitudinaux de chaque fente sont convergentes vers une ligne commune. Les écoulements formés à la sortie de ces fentes se présentent comme trois écoulements laminaires distincts projetés sur ledit substrat et mis en présence par contact tangentiel réciproque. Pour mettre ces trois écoulements en contact tangentiel, les parois séparant les différentes fentes doivent être extrêmement minces et former en particulier à la sortie de ces écoulements, des arêtes aussi vives que possible. La réalisation d'une telle buse sur une longueur pouvant atteindre jusqu'à 3 mètres par exemple pose des problèmes extrêmement complexes du point de vue de la fabrication. Il faut en effet que la largeur de chacune des fentes de la buse soit rigoureusement constante sur toute sa longueur, faute de quoi la proportion des gaz distribués ne serait pas régulière et se traduirait par un dépôt de matière non homogène. Non seulement une telle buse présente des difficultés d'usinage, mais encore, sa température de travail qui se situe aux environs de 110°C constitue un autre facteur susceptible de modifier l'écartement des fentes de la buse et notammentla régularité de cet écartement, qui risque de compromettre sérieusement la mise en oeuvre du procédé.

Les irrégularités des fentes de la buse ont des répercussions extrêmement défavorables sur la qualité du dépôt. Dans le cas du dépôt de $SnO_2$, ces irrégularités peuvent entraîner la formation de poudre blanche à la surface du substrat et à la sortie de la buse, obstruant progressivement le passage. Une variation locale de la proportion entre les gaz réactifs peut aussi entraîner une variation de l'épaisseur de la couche et donner ainsi des reflets irisés à la surface du verre. Etant donné que la couche d'oxyde d'étain est déposée pour former une couche électriquement conductrice destinée au chauffage du verre en vue de son dégivrage en particulier, l'irrégularité d'épaisseur se traduit encore par une variation de résistivité de la couche et donc une répartition inégale du chauffage. Enfin ces variations locales de débit détruisent les conditions stoechiométriques de la réaction de sorte que l'on ne réunit plus les conditions optimales de mise en oeuvre du procédé.

Le but de la présente invention est de remédier au moins partiellement aux inconvénients susmentionnés.

A cet effet, la présente invention a pour objet une buse pour déposer en continu sur un substrat, une couche d'une matière solide par réaction d'au moins deux réactifs gazeux ou en suspension dans un gaz, mis en présence l'un de l'autre à proximité immédiate dudit substrat porté à une température voisine de la température de réaction de ces réactifs. Cette buse est caractérisée par le fait que son ouverture de distribution est constituée par une fente longitudinale, elle-même subdivisée en trois fentes parallèles par deux arêtes longitudinales intermédiaires, que cette ouverture de distribution est disposée a un sommet tronqué d'un espace prismatique, lesdites arêtes intermédiaires étant formées par deux arêtes longitudinales de deux rubans métalliques respectifs qui s'étendent sur toute la hauteur de cet espace prismatique, que des surfaces d'appui sont situées au voisinage de chacune des arêtes transversales de ces rubans et sont conformés pour leur donner des inclinaisons respectives passant par ledit sommet tronqué et pour subdiviser cet espace prismatique en trois volumes prismatiques sensiblement égaux, chacun de ces volumes présentant au moins une ouverture pour l'admission de l'un desdits réactifs qui de bouche dans la base de l'espace prismatique opposée au sommet de celui-ci, chacun desdits rubans etant relié par ses arêtes transversales respectives à des moyens de mise sous tension longitudinale pour les appliquer contre leurs surfaces d'appui respectives, et que les arêtes longitudinales des rubans, opposées aux dites fentes, sont fixées a ladite base de l'espace prismatique.

Le dessin annexé illustre schématiquement et à titre d'exemple une forme d'exécution de la buse, objet de la présente invention.

La figure 1 est une vue en coupe transversale de cette buse.

La figure 2 est une vue en coupe transversale à l'une des extrémités longitudinales de cette buse.

La figure 3 est une vue selon III—III de la figure 2.

La buse illustrée est destinée à fonctionner pour mettre en oeuvre le procédé décrit dans le brevet suisse No 628 600. Par conséquent, l'ensemble de l'installation prévue pour alimenter la buse en gaz réactif et pour déplacer le substrat vis-à-vis de la buse ne seront pas repris dans le cadre de cette description étant donné que ces éléments sortent du cadre de la présente invention qui se rapporte spécifiquement à une forme de réalisation de la buse destinée à rendre les conditions opératoires du procédé aussi proches que possible des conditions théoriques idéales et ceci même pour une buse susceptible de déposer un revêtement en continu sur un substrat de plusieurs mètres de largeur.

Dans l'exemple illustré, le corps de la buse est formé de trois éléments, respectivement d'alimentation 1, de répartition 2 et de distribution 3, l'alimentation 1 et la distribution 3 étant fixées élastiquement à l'élément de répartition 2 par des vis 4 pressant des rondelles Belleville 5. Des joints d'étanchéités 6 sont disposés entre ces parties assemblées.

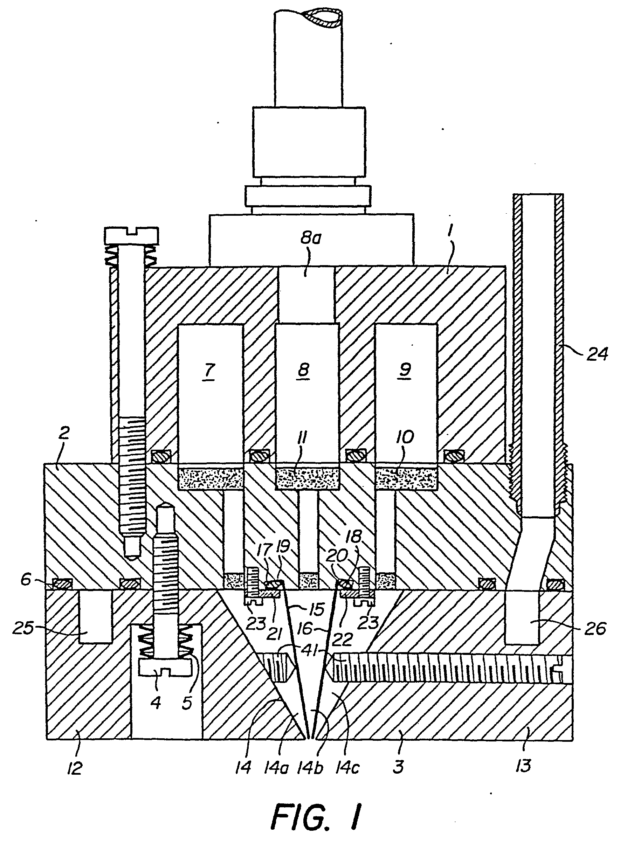

L'alimentation 1 de la buse comporte trois chambres 7, 8 et 9 s'étendant chacune sur toute la longueur du corps de la buse et présentant chacune une admission, seule l'admission 8a de la chambre 8 étant visible sur la figure 1 du fait que ces admissions sont décalées longitudinalement pour permettre la fixation de leurs conduits d'alimentation respectifs. L'élément de répartition comporte une pluralité de passages verticaux 10 reliant chaque logement 7, 8 et 9 à l'élément de distribution 3. Des garnitures 11 de mousse à pores ouverts en Teflon (marque déposée) sont disposées devant les entrées ainsi qu'à la sortie des passages verticaux 10. Ces garnitures servent à créer de fortes pertes de charge destinées à établir une répartition uniforme des gaz sur toute la longueur du corps de buse.

L'élément de distribution comporte deux profilés 12 et 13 dont les sections droites sont celles d'un trapèze rectangle et sont disposés en symétrie miroir par rapport au plan vertical médian du corps de la buse avec les angles aigus de ces sections droites adjacents à ce plan médian. Les faces inclinées de ces deux trapèzes délimitent entre elles un espace pris-prismatique 14 dont le troisième côté est fermé par la face inférieure de l'élément de répartition 2. Les sorties des trois séries de passages parallèles 10 débouchent dans la partie de la face inférieure de l'élément de répartition 2 fermant l'espace prismatique 14.

Cet espace 14 est subdivisé en trois par deux rubans métalliques 15 et 16 qui s'étendent longitudinalement sur toute la longueur de l'espace prismatique 14 et transversalement du côté de l'espace 14 formé par la face inférieure de l'élément de répartition 2 en direction du sommet du prisme opposé à cette face. Toutefois, cet espace 14 est formé par un prisme dont le sommet, adjacent aux deux faces inclinées des deux trapèzes rectangles constitués par les sections droites des profilés 12 et 13, est tronqué, de sorte que les deux arêtes formées par les angles aigus de ces trapèzes sont écartées et parallèles l'une à l'autre. Etant donné que les rubans 15 et 16 sont dirigés transversalement vers le sommet tronqué de l'espace prismatique 14, leurs arêtes aboutissant entre les arêtes écartées des profilés 12 et 13 et formant ainsi trois fentes de distribution parallèles, situées chacune à la sortie de l'un des volumes prismatiques 14a, 14b et 14c ménagés dans l'espace 14 par les rubans 15 et 16. Ces trois volumes 14a, b, c sont sensiblement égaux et les rubans 15 et 16 sont disposés de manière à ce que chaque volume 14a, b, c communique par une des séries de passages 10 avec les chambres 7, 8 et 9 respectivement. Chaque volume 14a, b, c est séparé du volume adjacent de façon étanche par un joint 17, respectivement 18 placé dans une rainure longitudinale 19, respectivement 20 dans chacune desquelles est introduit une des arêtes longitudinale des rubans 15, respectivement 16. Deux rubans de serrage 21 et 22 fixés par des vis 23 pressent les joints respectifs 17, 18 dans les logements 19, respectivement 20. De ce fait les arêtes longitudinales des rubans 15 et 16 sont ainsi serrées entre le bord des logements 19, respectivement 20 et les joints 17, respectivement 18.

Le corps de buse est encore parcouru par un circuit de circulation d'huile dont on voit un conduit d'admission 24 et deux canaux longitudinaux de circulation 25 et 26 ménagés dans les profilés 12, respectivement 13. Cette circulation d'huile est reliée à un système externe de thermostabilisation du corps de buse de manière à maintenir sa température aux environs de 110°C.

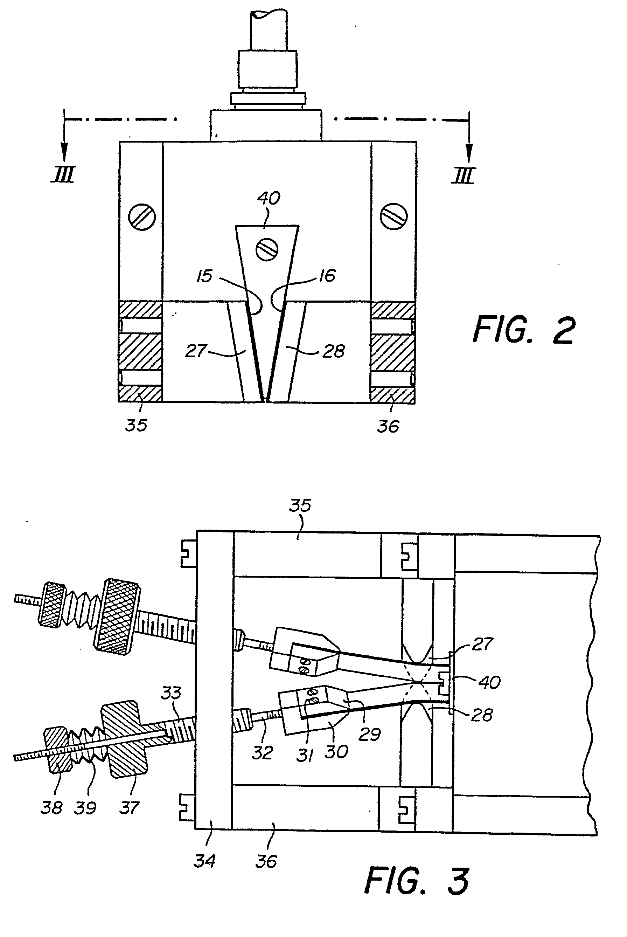

Les figures 2 et 3 illustrent les moyens de guidage et de fixation des rubans 15 et 16 aux deux extrémités du corps de buse. Chaque ruban 15, respectivement 16 repose contre une surface d'appui 27, respectivement 28 destinée à donner à ces rubans 15 et 16 leurs inclinaisons respectives de manière qu'ils divisent l'espace prismatique 14 en trois volumes sensiblement égaux, et pour que, transversalement, ces rubans soient orientés de manière à ce que leurs prolongements passent par le sommet tronqué de l'espace prismatique 14, de sorte que les arêtes de ces rubans ménagent trois fentes parallèles et de même largeur entre les arêtes des profilés 12 et 13. Les extrémités opposées des rubans 15 et 16 reposent contre deux surfaces de guidage identiques disposées à l'autre extrémité du corps de buse. Ces surfaces de guidage 27 et 28 sont fixées perpendiculairement à deux parois 35, respectivement 36 situées dans le prolongement du corps de buse.

Chaque extrémité de ces rubans est serrée entre deux mâchoires 29, 30 fixées par des vis 31. Le système de fixation étant identique pour les quatre extrémités des deux rubans, on ne décrira ici que l'une de ces fixations. L'une de ces mâchoires 30 est solidaire d'une tige filetée 32 engagé librement au travers d'un tube 33 fileté extérieurement. Ce tube 33 est vissé dans une plaque 34 fixée aux deux parois 35 et 36 situées dans le prolongement des profilés 12 respectivement 13 et portent les surfaces d'appui 27 et 28. Les ouvertures filetées dans lesquelle les tubes 33 sont vissés, sont écartées par rapport à un plan vertical passant par le sommet tronqué de l'espace prismatique 14 et forment un angle avec ce plan de manière que le sommet de cet angle se situe sensiblement au niveau des surfaces de guidage 27 et 28. Un écrou 37 est solidaire du tube 33, à l'extérieur de l'espace ménagé entre les parois 35, 36 et la plaque 34. Un second écrou 38 de réglage est vissé à l'extrémité extérieur de la tige 32 et des rondelles Belleville 39 sont interposées entre les écrous 37 et 38, pour empêcher une rotation intempestive de l'écrou de réglage 38.

Une pièce en forme de triangle 40 vissée à l'extrémité de l'élément de distribution 2 est disposée entre les surfaces d'appui 27 et 28 et sert à fermer l'extrémité de l'espace prismatique (14).

Compte tenu de cette force de traction et de l'angle avec lequel elle est exercée sur les extrémités des rubans 15 et 16, ceux-ci sont appliqués étroitement contre les surfaces d'appui 27 et 28 et prennent transversalement la même inclinaison que celle de ces surfaces d'appui. Etant donné que la précision des surfaces d'appui peut atteindre un degré élevé, notamment en ce qui concerne l'inclinaison et le centrage au sommet tronqué de l'espace prismatique 14, l'application des rubans 15 et 16 contre les surfaces avec une certaine tension permet de maintenir la même position rigoureusement tout au long de la buse, de sorte quie l'écartement des trois fentes de distributions ménagées entre les arêtes des profilés 12 et 13 sera maintenu régulier et ceci, indépendemment des questions de dilatation en raison des forces de traction élastique exercée sur ces rubans.

Des vis de correction 41 traversent les profilés 12 et 13 parallèlement aux faces parallèles de leurs sections en forme de trapèze rectangle et sensiblement a mi-distance de ces deux faces. Ces vis 41 sont destinées à agir sur les rubans 15 et 16. La planéité transversale des rubans 15 et 16 ne peut pas être parfaite, du fait que ces rubans sont forcément obtenus par découpage. Les forces de cisaillement qui enterviennent au cours de cette opération créent une légère déformation transversale du ruban. L'effort de traction exercé sur les rubans tend à accentuer cette déformation entre les deux surfaces de guidage 27, respectivement 28 en donnant une forme très légèrement arquée dans le sens transversal du ruban. Les vis de correction 41 réparties tout le long de l'espace prismatique 14 sont destinées à agir du côté de la convexité des rubans 15 et 16 qui seront orientés de façon que cette convexité soit tournée du côté des vis 41. Une légère pression de ces vis contre le milieu des rubans et ceci à distance régulière tout le long de chacun de ces rubans permet de rétablir la planéité transversale des rubans sans affecter par ailleurs la rectitude de l'arête libre de ces rubans tendus aux deux extrémités.

Un soin particulier sera apporté à la finition des pièces entrant dans la formation de l'espace prismatique 14 et des rubans de séparation longitudinale 15 et 16 de cet espace, notamment en ce qui concerne l'état de surfaces de ces pièces de manière à garantir un écoulement "laminaire" et tangentiel des rideaux de gaz jusqu'à qu'ils se recontrent au sommet de l'espace prismatique 14 où doit avoir lieu la réaction et coïncidant avec le substrat à recouvrir. En outre toutes le surfaces en contact avec les gaz réactifs seront en un matériau résistant à la corrosion engendrée par ces gaz. Dans cet exemple, toutes ces surfaces y compris celles des rubans 15 et 16 ont été dorées par dépôt galvanique. Les essais réalisés à l'aide d'une telle buse ont permis de réaliser des revêtements d'une qualité et d'une régularité extrêmement satisfaisantes.

**Revendications**

1. Buse pour déposer en continu sur un substrat, une couche d'une matière solide par réaction d'au moins deux réactifs gazeux ou en suspension dans un gaz, mis en présence l'un de l'autre à proximité immédiate dudit substrat porté à une température voisine de la température de réaction de ces réactifs, caractérisée par le fait que l'ouverture de distribution de cette buse est constituée par une fente longitudinale, elle-même subdivisée en trois fentes parallèles par deux arêtes, longitudinales intermédiaires, que cette ouverture de distribution est disposée tronqué d'un espace prismatique (14), lesdites arêtes intermédiaires étant formées par deux arêtes longitudinales de deux rubans métalliques (15, 16) respectifs qui s'étendent sur toute la hauteur de cet espace prismatique, que des surfaces d'appui (27, 28) sont situées au voisinage de chacune des arêtes transversales de ces rubans et sont conformées pour leur donne des inclinaisons respectives passant par ledit sommet tronqué et pour subdiviser cet espace prismatique en trois volumes prismatiques (14a, b, c), sensiblement égaux, chacun de ces volumes présentant au moins une ouverture pour l'admission de l'un desdits reactifs, qui débouche dans la base de l'espace prismatique opposée ou sommet de celui-ci, chacun desdits rubans étant soumis par ses arêtes transversales respectives à des moyens de mise sous tension longitudinale pour les appliquer contre leurs surfaces d'appui (27, 28) respectives et que les arêtes longitudinales des rubans, opposées aux dites fentes, sont fixées à ladite base de l'espace prismatique.

2. Buse selon la revendication 1, caractérisé par le fait qu'une pluralité de vis de butées réglables (41) traversent les deux faces dudit espace prismatique adjacentes audit sommet tronqué de façon à venir en contact avec les portions de ces rubans situées sensiblement au milieu de leurs largeurs et corriger les défauts éventuels de planéité transversale de ces rubans.

3. Buse selon la revendication 1, caractérisée par le fait que les arêtes longitudinales respectives de ces rubans opposées aux arêtes subdivisant ladite buse sont reliées à la base de l'espace prismatique opposée audit sommet tronqué par des moyens d'étanchéité (17—23).

4. Buse selon la revendication 1, caractérisée par le fait que les ouvertures respectives desdits volumes prismatiques (14a, b, c) pour l'admission des réactifs sont garnies par une couche de mousse à pores ouverts (11) en un matériau résistant à la corrosion et à une température de l'ordre de 110°C pour garantir une répartition uniforme des gaz sur toute la longueur de ces volumes prismatiques.

5. Buse selon la revendication 1, characterisée par le fait que lesdits moyens de mise sous tension longitudinale agissent sur les arêtes transversales desdits rubans par l'intermédiaire d'éléments élastiques de compression (39).

6. Buse selon la revendication 1, caractérisée par le fait que ledit espace prismatique (14) est formé entre une des faces d'un élément de répartition des gaz (2) et un élément de distribution (3) présentant deux profiles (12, 13) dont les sections droites sont celles de trapèzes rectangles dont les angles aigus sont adjacents et disposés en symétrie miroir, ces profilés délimitant entre eux au niveau des dits angles aigus ladite fente longitudinale, chacun d'eux étant fixé audit élément de distribution par l'intermédiaire d'organes de compression élastiques (5) disposés entre une vis (4) solidaire de l'élément de distribution et lesdits profilés respectifs, des joints d'étanchéite (6) étant interposés entre cet élément de distribution et ces profilés et par le fait que trois séries de passages (10) aboutissent dans la face dudit espace prismatique délimité par l'élément de répartition, chaque série de passages reliant l'un desdits volumes prismatiques subdivisés par lesdits rubans, à un élément d'alimentation (7, 8, 8a, 9).

7. Buse selon la revendication 1, caractérisée par le fait qu'au moins une des arêtes transversales de chacun desdits rubans (15, 16) est tenue entre deux mâchoires (29, 30) de serrage solidaires d'une vis (32) qui passe librement à travers un organe tubulaire (33) solidaire d'une partie fixe (34) de la buse et dont la portion ressortant de cet organe tubulaire est en prise avec un écrou (38), un élément de compression élastique (39) étant interposé entre cet écrou et l'extrémité dudit organe tubulaire.

**Patentansprüche**

1. Gebläse zum kontinuierlichen Ablagern einer Feststoffschicht auf einem Substrat mittels Reaktion mindestens zweier gasförmiger oder in einem Gas in Lösung befindlicher Reaktionsmittel, die in unmittelbarer Nähe des auf eine nahe der Reaktionstemperatur dieser Reaktionsmittel liegende Temperatur gebrachten Substrats zusammengebracht werden, dadurch gekennzeichnet, daß die Verteileröffnung des Gebläses aus einem Längsschlitz besteht, der seinerseits mittels zweier länglicher Zwischenkanten in drei Schlitze unterteilt ist, daß die Verteileröffnung an einer abgestumpften Spitze eines prismatischen Raumes (14) angeordnet ist, wobei die Zwischenkanten von zwei Längskanten zweier Metallbänder (15, 16) gebildet werden, die sich über die gesamte Höhe des prismatischen Raums erstrecken, daß Abstützflächen (27, 28) nahe einer jeden der Querkanten dieser Bänder liegen und so gestaltet sind, daß sie ihnen entsprechende Neigungen verleihen, während sie durch die abgestumpfte Spitze laufen, und daß sie den prismatischen Raum in drei im wesentlichen gleiche prismatische Räume (14a, b, c) unterteilen, wobei jeder dieser Räume mindestens eine Öffnung zum Einlassen eines der Reaktionsmittel aufweist, die in die Basis des prismatischen Raums gegenüber der Spitze desselben einmündet, und wobei jedes der Bänder mittels seiner entsprechenden Querkanten Mitteln zum Verbringen unter Längsspannung unterworfen ist, um sie gegen ihre entsprechenden Abstützflächen (27, 28) anzulegen, und daß die Längskanten der diesen Schlitzen gegenüberliegenden Bänder an der Basis des prismatischen Raums befestigt sind.

2. Gebläse nach Anspruch 1, dadurch gekennzeichnet, daß eine Vielzahl von regelbaren Anschlagschrauben (41) die beiden Seiten des prismatischen Raums nahe der abgestumpften Spitze derart durchqueren, daß sie mit den Abschnitten dieser Bänder in Berührung kommen, die im wesentlichen in der Mitte ihrer Breiten liegen, und die möglichen Mängel bezüglich der Ebenheit dieser Bänder in Querrichtung korrigieren.

3. Gébläse nach Anspruch 1, dadurch gekennzeichnet, daß die entsprechenden Längskanten der Bänder gegenüber den Kanten, die das Gebläse unterteilen, mit der Basis des prismatischen Raumes gegenüber der abgestumpften Spitze durch Dichtungsmittel (17 bis 23) verbunden sind.

4. Gebläse nach Anspruch 1, dadurch gekennzeichnet, daß die entsprechenden Öffnungen der prismatischen Räume (14a, b, c) zum Einlassen der Reaktionsmittel mit einer Schaumschicht mit offenen Poren (11) aus einem Material versehen sind, das korrosionsbeständig ist und einer Temperatur in der Größenordnung um 110°C widersteht, um eine gleichmäßige Aufteilung der Gase über die gesamte Länge der prismatischen Räume zu gewährleisten.

5. Gebläse nach Anspruch 1, dadurch gekennzeichnet, daß die Mittel zum Verbringen unter Längsspannung mit Hilfe von federnden Kompressionselementen (39) auf die Querkanten der Bänder einwirken.

6. Gebläse nach Anspruch 1, dadurch gekennzeichnet, daß der prismatische Raum (14) zwischen einer der Seiten eines Aufteilungselements für die Gase (2) und einem Verteilerelement (3) mit zwei Profilen (12, 13) gebildet ist, deren Querschnitte die Form rechteckiger Trapeze haben, deren spitze Winkel nebeneinander liegen und spiegelsymmetrisch angeordnet sind, wobei diese Profile zwischen sich auf der Ebene der spitzen Winkel den Längsschlitz begrenzen, und jedes von ihnen am Verteilerelement mit Hilfe von federnden Kompressionsorganen (5) befestigt ist, die zwischen einer Schraube (4), die mit dem Verteilerelement formschlüssig verbunden ist, und den entsprechenden Profilen befestigt sind, wobei Dichtungen (6) zwischen dem Verteilerelement und den Profilen eingefügt sind, und dadurch, daß drei Reihen von Durchgängen (10) in die Fläche des prismatischen Raumes einmünden, der von dem Aufteilelement begrenzt ist, wobei jede Durchgangsreihe einen der von den Bändern unterteilten prismatischen Räume mit einem Speiseelement (7, 8, 8a, 9) verbindet.

7. Gebläse nach Anspruch 1, dadurch gekennzeichnet, daß mindestens eine der Querkanten eines jeden Bandes (15, 16) zwischen zwei Spannbacken (29, 30) gehalten wird, die mit einer Schraube (32) formschlüssig verbunden sind, die frei durch ein rohrförmiges Organ (33) verläuft, das mit einem festen Teil (34) des Gebläses formschlüssig verbunden ist, und deren aus dem rohrförmigen Organ austretendes Teil mit einer Schraubenmutter (38) in Eingriff steht, wobei ein federndes Kompressionselement (39) zwischen der Schraubenmutter und dem Ende des rohrförmigen Organs eingesetzt ist.

**Claims**

1. A nozzle for continuously depositing on a substrate a layer of a solid substance by the reaction of at least two gaseous reagents or reagents in suspension in a gas, brought together in the immediate proximity of the said substrate which has been brought to a temperature close to the reaction temperature of the two reagents, characterised in that the distribution aperture of this nozzle is formed by a longitudinal slit which in turn is subdivided into three parallel slits by two intermediate longitudinal knife-edges, in that this distribution aperture is disposed at a truncated apex of a prismatic space (14), the said intermediate knife-edges being formed by two longitudinal edges of two respective metal strips (15, 16) which extend over the entire height of the prismatic space, in that support surfaces (27, 28) are situated near each of the transverse edges of these strips and are shaped so as to give them respective inclinations passing through the said truncated apex and so as to subdivide the prismatic space into three substantially equal prismatic chambers (14a, b, c), each of these chambers having at least one aperture for the entry of one of the said reagents which opens into the base of the prismatic space opposite the apex thereof, each of the said strips being subjected by meaning of its respective transverse edges to longitudinal tensioning means in order to apply them against their respective support surfaces (27, 28), and in that the longitudinal edges of the strips, opposite the said slits, are fixed to the said base of the prismatic space.

2. A nozzle according to claim 1, characterised in that a plurality of adjustable thrust screws (41) extend through the two faces of the said prismatic space adjacent to the said truncated apex in such a way as to come into contact with the portions of the said strips situated substantially in the middle of their widths and to correct any departure from transverse flatness of the strips.

3. A nozzle according to claim 1, characterised in that the respective longitudinal edges of these strips opposite the edges which subdivide the said nozzle are connected to the base of the prismatic space opposite the said truncated apex by sealing means (17—23).

4. A nozzle according to claim 1, characterised in that the respective apertures of the said prismatic chambers (14a, b, c) for the entry of the reagents are provided with a layer of open-pore foam (11) of a material which is resistant to corrosion and to a temperature of the order of 110°C so as to guarantee a uniform distribution of the gases over the entire length of the prismatic chambers.

5. A nozzle according to claim 1, characterised in that the said longitudinal tensioning means act on the transverse edges of the said strips by means of resilient compression elements (39).

6. A nozzle according to claim 1, characterised in that the said prismatic space (14) is formed between one of the faces of a gas division element (2) and a distribution element (3) having two sections (12, 13), the cross-sections of which are those of right-angled trapezia, the acute angles of which are adjacent and are disposed in a mirror symmetrical manner, these sections delimiting between them at the said acute angles the said longitudinal slit, each of the sections being fixed to the said distribution element by means of resilient compression members (5) disposed between a screw (4) rigid with the distribution element and the said respective sections, seals (6) being interposed between the distribution element and the said sections, and in that three series of passages (10) emerge on the face of the said prismatic space which is delimited by the division element, each series of passages connecting one of the said prismatic chambers subdivided by the said strips to a feed element (7, 8, 8a, 9).

7. A nozzle according to claim 1, characterised in that at least one of the transverse edges of each of the said strips (15, 16) is held between two securing clamps (29, 30) rigid with a screw (32) which passes freely through a tubular member (33) rigid with a fixed part (34) of the nozzle and the portion of which screw projecting from this tubular member engages with a nut (38), a resilient compression element (39) being interposed between this nut and the end of the said tubular member.

FIG. I

FIG. 2

FIG. 3

2